# EUROPEAN PATENT APPLICATION

(11) **EP 2 139 112 A1**
(43) Date of publication of application: **30.12.2009**
(21) Application number: 09008167.0
(22) Date of filing: 22.06.2009
(51) Int. Cl.: H03J 3/18, H03J 3/26, H03J 5/24

(54) **Double-tuned circuit**

(30) Priority: 25.06.2008 JP 2008165503
(71) Applicant: Alps Electric Co., Ltd., Tokyo 145-8501 (JP)
(72) Inventor: Yamamoto, Masaki, Tokyo 145-8501 (JP)
(74) Representative: Schraud, Robert Alexander

(57) **Abstract**

A band-switching double-tuned circuit (30) includes a primary tuned circuit formed of a circuit having a first inductance element (L1, L2) and a first variable capacitance element (VD1) connected parallel to each other, and a secondary tuned circuit formed of a circuit having a second inductance element (L4, L5) opposed to the first inductance element (L1, L2) and a second variable capacitance element (VD3) connected parallel to each other, wherein a trap circuit is formed by connecting a first capacitance (C11) between a connection point (P1) of the second inductance element (L4, L5) and the second variable capacitance element (VD3) and a middle point (P2) of the first inductance element (L1, L2).

## Description

THIS APPLICATION CLAIMS BENEFIT OF JAPANESE PATENT APPLICATION NO. 2008-165503 FILED ON JUNE 25, 2008, WHICH IS HEREBY INCORPORATED BY REFERENCE.

### BACKGROUND

### 1. Technical Field

The present invention relates to a double-tuned circuit applicable to a band-switching RF tuned circuit in a television tuner or the like.

### 2. Related Art

Digital television tuners have been developed to receive digital television signals transmitted by terrestrial waves or cable waves (CATV). In such digital television tuners, when a signal in the vicinity of a frequency of a local oscillation signal together with a received digital television signal is input to a mixer, change of oscillation frequency, which is called Pulling, occurs in the frequency of the local oscillation signal. As a result, phase distortion of an intermediate frequency signal deteriorates, and a bit error occurs at the time of demodulation. In consideration of this problem, a double-tuned circuit was proposed in which a local oscillation frequency is provided with an attenuation pole. An example of the related art is Japanese Unexamined Patent Application Publication No. 2000-333087.

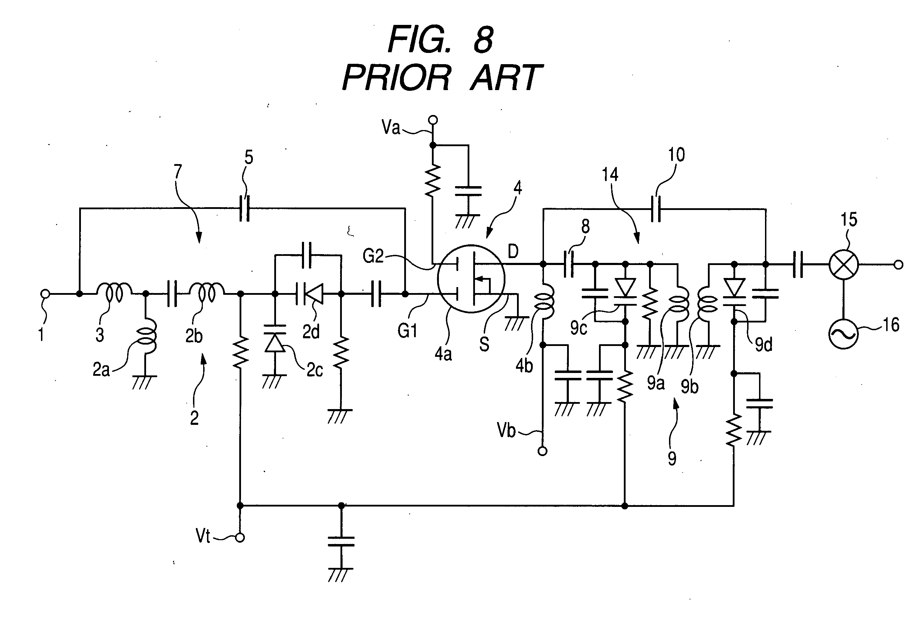

Fig. 8 is a diagram illustrating the known digital television tuner. A single-tuned circuit 2 for frequency-selecting a received digital television signal is connected to an antenna input terminal 1 through an inductance element 3 for impedance matching, and a high frequency amplifier 4 having an FET 4a is connected to an output terminal of the single-tuned circuit 2. The single-tuned circuit 2 includes two inductance elements 2a and 2b serially connected to each other at a high frequency, and two varactor diodes (second varactor diodes) 2c and 2d, cathodes of which are connected to each other, and which are connected to the other end of the inductance element 2b. The anode of the varactor diode 2d is connected to a first gate G1 of the FET 4a. The FET 4a of the high frequency amplifier 4 has two gates G1 and G2, and can change a gain by changing an AGC voltage Va applied to the second gate G2. A power voltage Vb is applied to a drain D through a choke inductor 4b, and a source S is grounded. A double-tuned circuit 9 is connected to the drain D of the FET 4a through a coupling capacitor 8.

The double-tuned circuit 9 includes a primary coil 9a and a secondary coil 9b as inductance elements, and two varactor diodes 9c and 9d connected parallel to the coils 9a and 9b at a high frequency. The primary coil 9a and the varactor diode 9c constitute a primary tuned circuit, and the secondary coil 9b and the varactor diode 9d constitute a secondary tuned circuit. The primary coil 9a and the secondary coil 9b are disposed to be inductively coupled to each other. A tuning frequency can be matched with a frequency of the received digital television signal by changing a tuning voltage Vt applied to the cathodes of the varactor diodes 9c and 9d.

A mixer 15 is connected to the output side (secondary tuned circuit) of the double-tuned circuit 9, and a local oscillation signal is input from a local oscillator 16 to the mixer 15. The digital television signal selected by the single-tuned circuit 2 and the double-tuned circuit 9 is frequency-converted in the mixer 15, and the frequency-converted signal is output as an intermediate signal.

A double-tuned circuit of a television tuner is conceivable in which each of the primary coil and the secondary coil constituting the inductor of the double-tuned circuit is divided into two parts, and the inductance values of the primary coil and the secondary coil are synchronized and switched by a switch circuit, a reception band is switchable between a high frequency side (high band) and a low frequency side (low band).

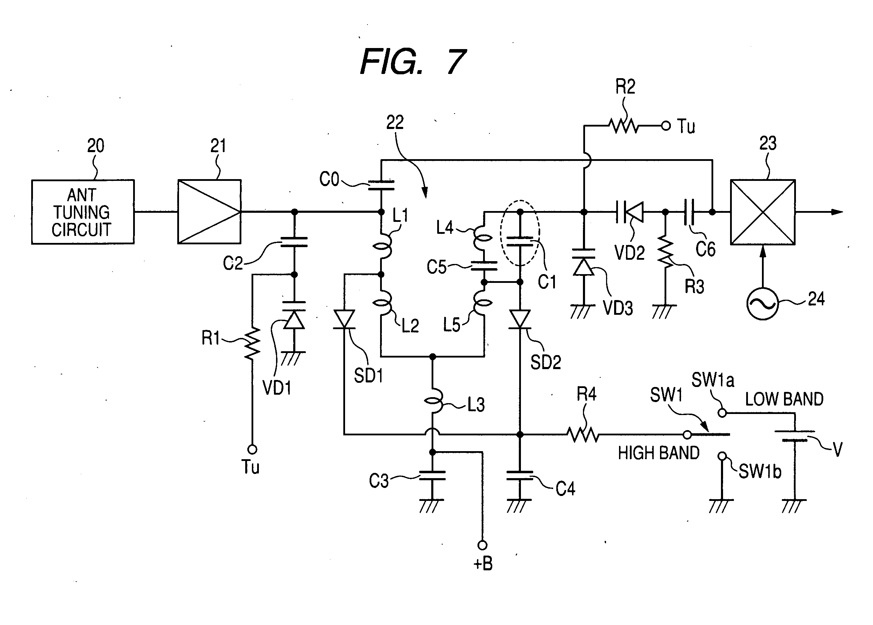

Fig. 7 is a circuit diagram illustrating a double-tuned circuit of a television tuner capable of switching the inductance values of a primary coil and a secondary coil by a switch circuit. An amplifier 21 is connected to an output terminal of an antenna tuning circuit 20, and a band-switching tuned circuit 22 is connected to an output terminal of the amplifier 21. An input terminal of a mixer 23 is connected to an output terminal of the double-tuned circuit 22. A primary tuned circuit of the double-tuned circuit 22 includes serially connected inductors L1 and L2, and a varactor diode VD1 connected parallel to the inductors L1 and L2. An anode of the varactor diode VD1 is connected to a ground, and a cathode thereof is connected to a hot side of the inductor L1 through a capacitor C2. A tuning voltage Tu is applied between the cathode and the capacitor C2. A cold side of the inductor L2 is connected to the ground through an inductor L3 and a capacitor C3 at a high frequency.

A secondary tuned circuit of the double-tuned circuit 22 includes serially connected inductors L4 and L5 coupled to the primary inductors L1 and L2, and a varactor diode VD3 connected parallel to the inductors L4 and L5. An anode of the varactor diode VD3 is connected to the ground. Cathodes of the varactor diodes VD2 and VD3 are connected to the hot side of the inductor L4, and the tuning voltage Tu is applied thereto through a resistor R2. The cold side of the inductor L5 is connected to the ground through the inductor L3 and the capacitor C3 at a high frequency. An output terminal of the secondary tuned circuit is connected to the mixer 23 through the varactor diode VD2. The anode of the varactor diode VD2 is connected to the ground through a resistor R3. The varactor diode VD2 has a variable-capacitance element characteristic having a low capacitance at a high voltage and a high capacitance at a low voltage and by virtue of this, a variable range of the secondary tuned circuit is secured, a coupling degree with a rear end circuit (mix circuit) at the time of receiving a channel in a low frequency band of bands(at the time of applying a low voltage) is secured by high capacitance, and a signal level input to the mix circuit is secured, thereby reducing a gain declination in each band. In case of a product (tuner) having a relatively narrow reception range, the varactor diode VD2 may not be disposed. The anode of the varactor diode VD2 is connected to the input terminal of the mixer 23 through a capacitor C6. The mixer 23 mixes a local oscillation signal supplied from an oscillator 24 with a high frequency signal output from the secondary tuned circuit, thereby converting a high frequency signal into an intermediate frequency.

The primary tuned circuit and the secondary tuned circuit of the double-tuned circuit 22 are synchronized with the reception band (high band/low band) by a band switching circuit including switching elements SD1 and SD2 and a switch circuit SW1, and are configured to switch inductance values. An anode of the switching element SD1 is connected to a connection point between the inductors L1 and L2 of the primary tuned circuit, and a cathode of the switching element SD1 is connected to the switch circuit SW1 through a bias resistor R4. A capacitor C5 is connected between the inductors L4 and L5 of the secondary tuned circuit, an anode of the switching element SD2 is connected to a connection point between the capacitor C5 and the inductor L5, and a cathode of the switching element SD2 is connected to the switch circuit SW1 through the resistor R4. The switch circuit SW1 is connected to a terminal SW1a applying a reverse voltage and turning the switching elements SD1 and SD2 off at the time of selecting the low band, and is connected to a terminal SW1b turning the switching elements SD1 and SD2 on at the time of selecting the high band.

A driving voltage (+B) of the amplifier 21 is supplied through the inductor L3 of the double-tuned circuit 22 and the inductors L2 and L1 of the primary tuned circuit, and the cathode of the varactor diode VD1 is connected to the hot side of the inductor L1 through the capacitor C2. Accordingly, an internal capacitance of the amplifier 21 is connected parallel to the primary tuned circuit, and has an influence on the variable range of the primary tuned circuit (the variable range is reduced). For this reason, even when the varactor diodes having the same variable range are used, the variable ranges on the primary side and the secondary side of the double-tuned circuit 22 are different from each other, particularly at the time of selecting the high band. Thus, a capacitor C1 is connected parallel to the inductor L4 of the secondary tuned circuit, thereby correcting the capacitance variable range at the time of selecting the high band and matching the variable ranges on the primary side and the secondary side with each other.

The double-tuned circuit 22 is provided with a trap circuit for attenuating an image band. The trap circuit is formed by connecting a trap forming capacitor C0 between the hot side of the inductor L1 of the primary tuned circuit and the output terminal of the secondary tuned circuit.

However, in the double-tuned circuit using the switching method, a bandwidth (-3 dB) at the time of low band reception tends to become wider than a bandwidth (-3 dB) at the time of high band reception, and it is difficult to sufficiently attenuate a local oscillation frequency band, due to the problem that, relying only on the correction of the trap forming capacitor C0, it is difficult to optimally position an attenuation pole of the trap circuit in the high and low bands and due to a circuit constituent problem. For this reason, when interference waves of the local oscillation frequency band are input, it is difficult to sufficiently attenuate them by the double-tuned circuit. Accordingly, the interference waves may become mixed into the mixer 23 and have a bad influence on reception performance.

### SUMMARY

An advantage of some aspects of the invention is to provide a double-tuned circuit capable of forming a trap circuit with a simple circuit configuration without increasing the number of components, capable of realizing a wide band of a trap frequency in combination with the known trap circuit, and capable of sufficiently attenuating both an oscillation frequency band and an image signal.

According to a first aspect of the invention, there is provided a double-tuned circuit including: a primary tuned circuit formed of a circuit having a first inductance element and a first variable capacitance element connected parallel to each other; and a secondary tuned circuit formed of a circuit having a second inductance element opposed to the first inductance element and a second variable capacitance element connected parallel to each other, wherein a trap circuit is formed by connecting a first capacitance between a connection point of the second inductance element and the second variable capacitance element and a middle point of the first inductance element.

With such a configuration, since the trap circuit is formed by connecting the first capacitance between the connection point of the second inductance element and the second variable capacitance element and the middle point of the first inductance element, it is possible to match the capacitance variable ranges on the primary side and the secondary side with a simple circuit configuration and to form the trap circuit having the attenuation pole at a predetermined frequency simply by adjusting the first capacitance. Accordingly, it is possible to realize a wide band of the trap frequency in combination with the known trap circuit, and it is possible to sufficiently attenuate both the oscillation frequency and the image signal even when the image band is close to the desired wave.

In the double-tuned circuit, it is preferable that a mixer circuit that converts a frequency by mixing a high frequency signal output from the secondary tuned circuit with an oscillation signal supplied from an oscillation circuit is connected to a rear end of the secondary tuned circuit, and an attenuation pole of the trap circuit is set for an oscillation frequency of the oscillation circuit.

With such a configuration, since the attenuation pole of the trap circuit, which is formed by connection to the first capacitance, can be set for the oscillation frequency of the oscillation circuit, it is possible to sufficiently attenuate the oscillation frequency band.

In the double-tuned circuit, it is preferable that the inductance values of the first and second inductance elements are switchable according to reception bands. With such a configuration, since the inductance values are switched according to the reception bands, the primary side and the secondary side are synchronized with each other to cause resonant frequency conversion, thereby receiving the desired band.

In the double-tuned circuit, it is preferable that a second capacitance is connected between an output terminal of the secondary tuned circuit and the mixer circuit. With such a configuration, when a driving voltage is applied to a high frequency amplifier through the first inductance element of the primary tuned circuit, the variable range of the primary tuned circuit is limited by the internal capacitance of the high frequency amplifier. Accordingly, when the capacitance variable ranges on the primary side and the secondary side deviate from each other, the first capacitance corrects both of the capacitance variable ranges to coincide with each other.

In the double-tuned circuit, it is preferable that the first capacitance is formed of a conductive pattern formed from the connection point of the second inductance element and the second variable capacitance element to the middle point of the first inductance element. With such a configuration, it is possible to form the trap circuit without increasing the number of components.

According to the invention, it is possible to form the trap circuit with a simple circuit configuration without increasing the number of components, it is possible to realize the wide band of the trap frequency in combination with the known trap circuit, and it is possible to sufficiently attenuate both the oscillation frequency band and the image signal.

### BRIEF DESCRIPTION OF THE DRAWINGS

Fig. 1 is a diagram illustrating a band-switching tuned circuit according to an embodiment of the invention.
Fig. 2 is a diagram illustrating the disposition of components on both sides of a band-switching double-tuned circuit according to the embodiment.
Fig. 3A is an equivalent circuit diagram at the time of low band reception according to the embodiment.
Fig. 3B is an equivalent circuit diagram at the time of high band reception according to the embodiment.
Fig. 4A is a diagram illustrating a simulation result of frequency characteristics using an exemplary circuit model shown in Fig. 2A.
Fig. 4B is a diagram illustrating a simulation result of frequency characteristics using a comparative circuit model shown in Fig. 6A.
Fig. 5A is a diagram illustrating a simulation result of frequency characteristics using an exemplary circuit model shown in Fig. 2B.
Fig. 5B is a diagram illustrating a simulation result of frequency characteristics using a comparative circuit model shown in Fig. 6B.
Fig. 6A is an equivalent circuit diagram of a comparative circuit model at the time of low band reception.
Fig. 6B is an equivalent circuit diagram of a comparative circuit model at the time of high band reception.
Fig. 7 is a diagram illustrating a band-switching tuned circuit in which the primary and secondary variable ranges are matched.
Fig. 8 is a circuit diagram illustrating a known television tuner provided with a double-tuned circuit.

### DESCRIPTION OF EXEMPLARY EMBODIMENTS

Hereinafter, an embodiment of the invention will be described in detail with reference to the accompanying drawings.

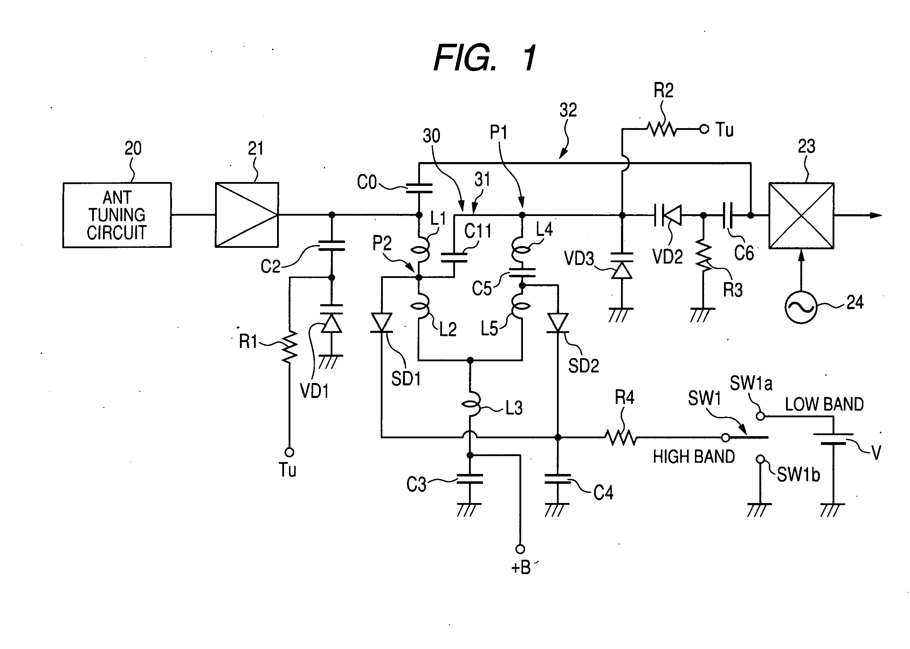

Fig. 1 is a diagram illustrating a band-switching tuned circuit according to an embodiment of the invention. The same reference numerals and signs are given to the same parts as those of the double-tuned circuit of the television tuner shown in Fig. 7, and the description thereof is omitted.

In a band-switching double-tuned circuit 30 according to the embodiment, a conductive pattern 31 is formed between a hot side P1 of an inductor L4 of a secondary tuned circuit and a cold side P2 of an inductor L1 of a primary tuned circuit, and the hot side of the secondary inductor L4 and the cold side P2 of the primary inductor L1 are coupled to each other through a small capacitance C11. The capacitance C11 may be formed of a capacitance formed between the conductive pattern 31 and a circuit board. Alternately, the capacitance C11 may be formed by cutting the conductive pattern 31 and disposing an electric connection chip component to connect both ends corresponding to the cut conductive pattern 31. The secondary point P1 and the primary point P2 are connected through the capacitance C11 and a closed loop, which includes the primary inductor L2, is formed by the capacitance C11 in a state in which switching elements SD1 and SD2 are turned off (at the time of low band reception).

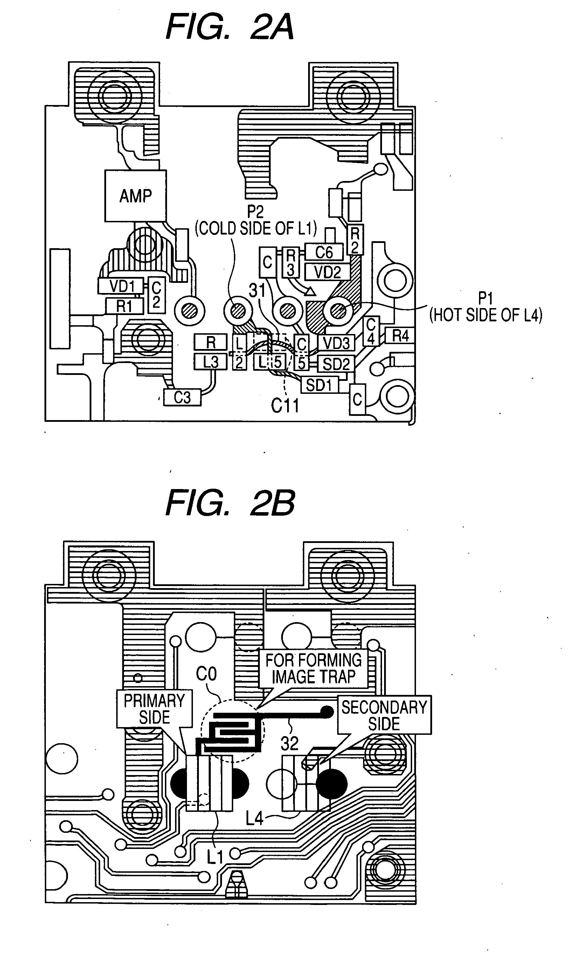

Fig. 2A and Fig. 2B are diagrams illustrating the disposition of components of the band-switching double-tuned circuit 30. Fig. 2A shows the components disposed on one side of the circuit board on which an amplifier 21 is mounted, and Fig. 2B shows the components disposed on the other side. As shown in Fig. 2A, the conductive pattern 31 is formed from the hot side P1 of the secondary inductor L4 to the cold side P2 of the primary inductor L1. The capacitance C11 is formed according to both the opposing areas between the conductive pattern 31 and the circuit board. Alternately, the capacitance C11 may be formed by cutting the pattern indicated by the dotted line and, for example, disposing an electric connection chip element. A chip capacitor having a small capacitance may be mounted instead of the electric connection chip component. That is, the capacitance C11 is determined depending on the opposing areas of the conductive pattern 31 and the circuit board, the size of the chip component, and the capacitance of the chip capacitor, and thus it is possible to easily adjust the capacitance C11. The capacitance C11 is set so that an attenuation pole appears at a local oscillation frequency. As for the capacitor C0, the capacitance C11 is adjusted so that the attenuation pole formed in the vicinity of an image frequency and a local oscillation frequency widens between an attenuation pole of the trap circuit formed by the capacitor C0 and an attenuation pole of the trap circuit formed by the capacitance C11.

As shown in Fig. 2B, the primary inductor L1 and the secondary inductor L4 are disposed on the other side of the circuit board. A conductive pattern 32 is formed from an input terminal of the mixer 23 to the hot side of the primary inductor L1. The middle of the conductive pattern 32 is formed in a pectinated shape, thereby forming the trap forming capacitor C0. The capacitance of the capacitor C0 is set so that adjusting the capacitance of the capacitor C0 makes the attenuation pole appear at the image frequency.

Next, an operation of the embodiment with such a configuration will be described.

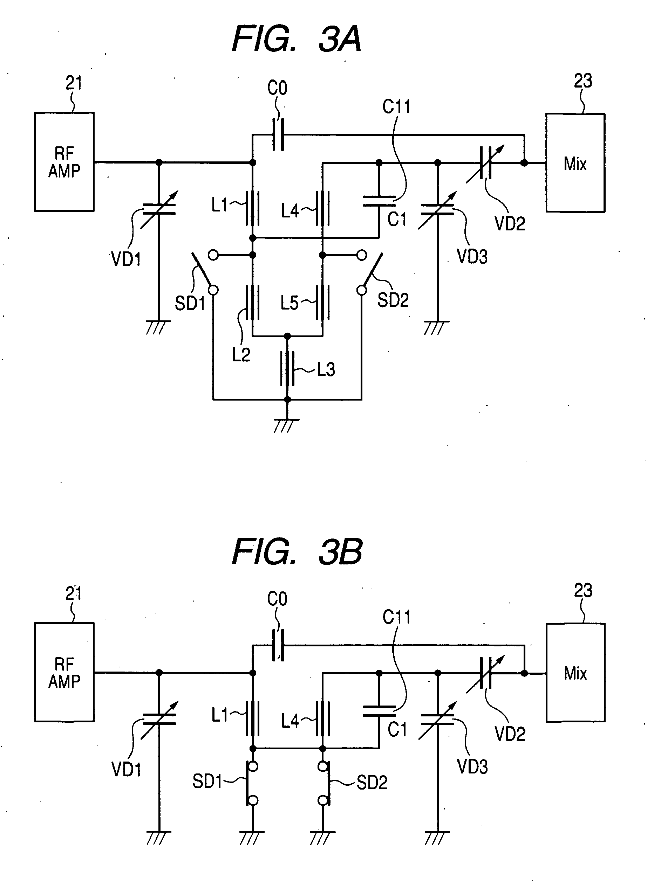

Fig. 3A shows an equivalent circuit at the time of low band reception, and Fig. 3B shows an equivalent circuit at the time of high band reception.

At the time of low band reception, the switch circuit SW1 is connected to a terminal SW1a, and a turning-off bias voltage V is applied to the cathodes of the switching elements SD1 and SD2 through the resistor R4. An amplifier voltage +B is applied to the anodes of the switching elements SD1 and SD2, but the turning-off bias voltage V > B is set, thereby turning the switching elements SD1 and SD2 off. As shown in Fig. 3A, when the switching elements SD1 and SD2 are turned off, the inductance element including the inductors L1 and L2 in the primary tuned circuit is terminated through the inductor L3, and the inductance element including the inductors L4 and L5 in the secondary tuned circuit is terminated through the inductor L3.

In this case, since the hot side P1 of the secondary inductor L4 and the cold side P2 of the primary inductor L1 are connected through the small capacitance C11, a closed loop including the inductors L2, L5, L4, and the capacitance C11 is formed. Accordingly, the variable capacitance range of the varactor diode VD2 is suppressed by the small capacitance C11 connected parallel to the inductor L4 and the secondary variable range and the primary variable range are thereby corrected to coincide with each other. The primary tuned circuit and the secondary tuned circuit are connected to each other through the small capacitance C11, thereby forming the trap circuit. That is, a combined trap of the trap formed by the capacitor C0 and the trap formed by the capacitance C11 is formed, and both trap frequencies are adjusted into the image band and the local oscillation frequency band. Accordingly, it is possible to attenuate the vicinity of the trap frequency in the wide band.

At the time of high band reception, the switch circuit SW1 is connected to a terminal SW1b, and the amplifier driving voltage +B is applied only to the anodes of the switching elements SD1 and SD2. The switching elements SD1 and SD2 are turned on by the amplifier driving voltage +B applied to the anodes. As shown in Fig. 3B, in the primary tuned circuit, the cold side of one inductor L1 passes through the turned-on switching element SD1, and is grounded through the capacitor C4 at a high frequency. In the secondary tuned circuit, the cold side of one inductor L4 passes through the turned-on switching element SD2, and is grounded through the capacitor C4 at a high frequency.

In this case, the capacitance C11 is grounded through the switching element SD1. In the double-tuned circuit 22 shown in Fig. 7, the capacitor C1 is grounded through the switching element SD2. Accordingly, even when one end of the capacitance C11 is connected to either the primary side or the secondary side, the electrical configuration is the same.

Next, simulation results of frequency characteristics in a circuit model (Example) based on the double-turned circuit 30 according to the embodiment and a circuit model (Comparative Example) based on the double-tuned circuit 22 shown in Fig. 7 will be described.

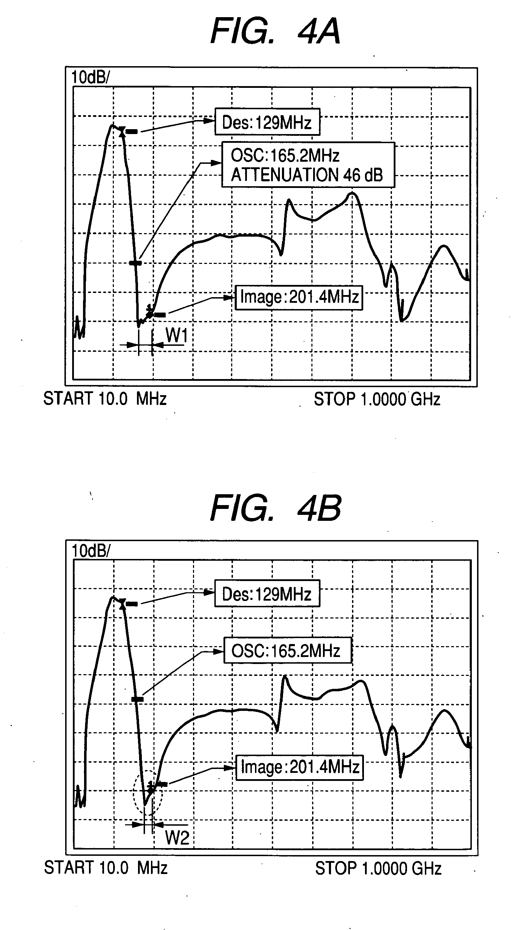

Fig. 4A is a diagram illustrating a simulation result of frequency characteristics using an exemplary circuit model shown in Fig. 2A. In a case in which the desired wave is a top channel (129 MHz) of a VHF low band, when an intermediate frequency is set to 36.2 MHz and a local oscillation frequency is set to 165.2 MHz, an image band is 201.4 MHz. As shown in Fig. 4A, an attenuation pole W1 formed in the vicinity of the image band widens up to the vicinity of the local oscillation frequency band, and attenuation of the local oscillation frequency band is 46 dB. Accordingly, it can be seen that sufficient attenuation is realized.

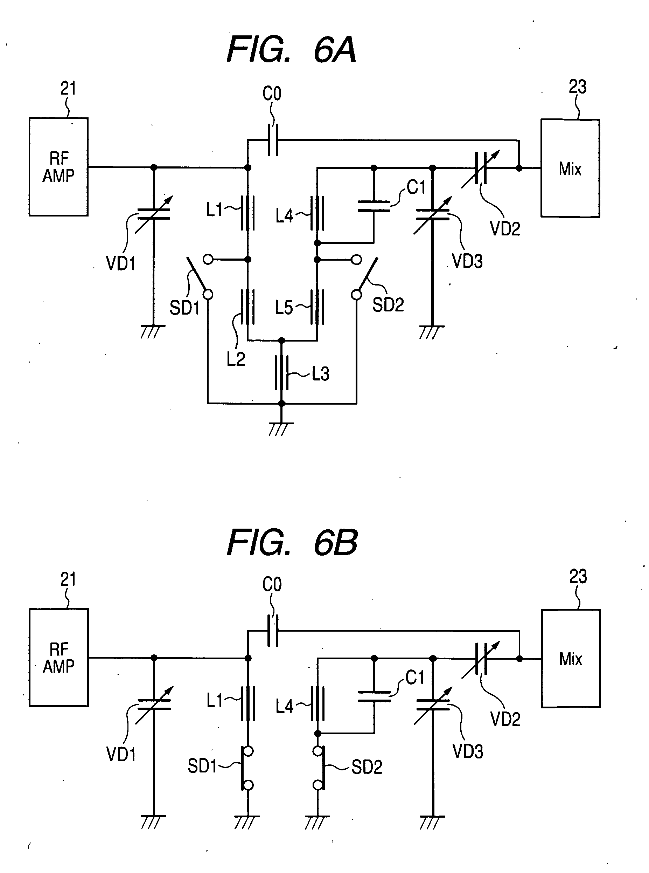

Fig. 4B is a diagram illustrating a simulation result of frequency characteristics using a comparative circuit model shown in Fig. 6A. In the comparative circuit model shown in Fig. 6A, the capacitor C1 is connected parallel to the secondary inductor L4. The trap circuit is only what is formed by the capacitor C0. As shown in Fig. 4B, an attenuation pole W2 becomes narrow. Accordingly it can be seen that attenuation in the vicinity of the local oscillation frequency band is insufficient.

As described above, by comparing the attenuation in the vicinity of the local oscillation frequency band of the exemplary circuit model with that of the comparative circuit model at the time of low band reception, it can be seen that the exemplary circuit model secures attenuation of +11 dB.

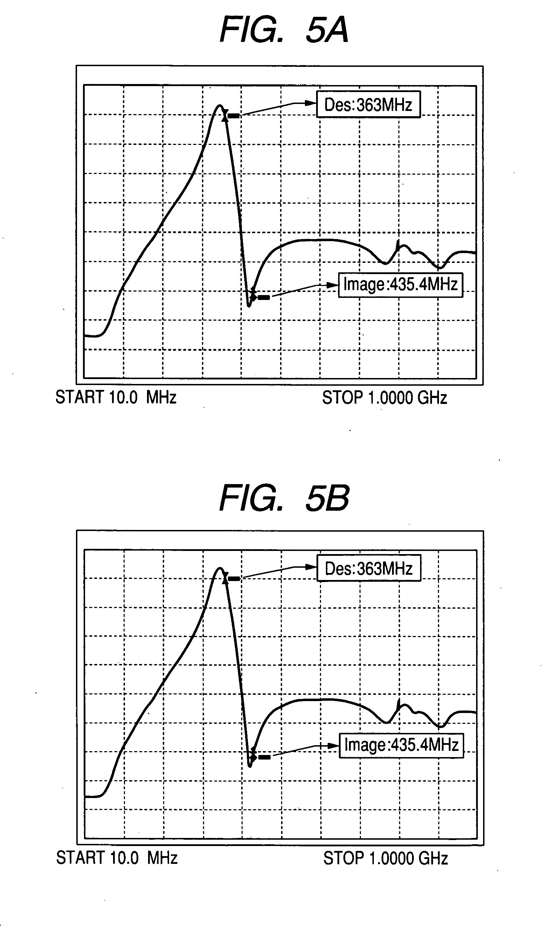

Fig. 5A is a diagram illustrating a simulation result of frequency characteristics using an exemplary circuit model shown in Fig. 2B. In a case in which the desired wave is a top channel (363 MHz) of a VHF high band, when an intermediate frequency is set to 36.2 MHz and a local oscillation frequency is set to 399.2 MHz, an image band is 435.4 MHz. A bandwidth (-3 dB) at the time of VHF high band reception tends to be narrower than a bandwidth (-3 dB) at the time of VHF low band reception. Accordingly, even when the attenuation pole is not widened as in the case of the low band reception, the lack of attenuation of the local oscillation frequency band does not have an adverse effect.

Fig. 5B is a diagram illustrating a simulation result of frequency characteristics using a comparative circuit model shown in Fig. 6B. As can be seen clearly by comparing the exemplary circuit model shown in Fig. 2B with the comparative circuit model shown in Fig. 6B, the only difference between the exemplary circuit model and the comparative circuit model is whether the capacitance C11 is grounded through the primary switching element SD1 (exemplary circuit model) or through the secondary switching element SD2 (comparative circuit model). Accordingly, both of the frequency characteristics are substantially the same.

As described above, according to the embodiment, the conductive pattern 31 is formed from the hot side P1 of the inductor L4 of the secondary tuned circuit to the cold side P2 of the inductor L1 of the primary tuned circuit, and the small capacitance C11 for coupling the primary tuned circuit and the secondary tuned circuit is formed. Accordingly, it is possible to form the trap circuit using the capacitance C11 that matches the primary and secondary variable ranges with each other. It is possible to realize the wide band of the attenuation pole throughout the double-tuned circuit in combination with the known trap circuit using the capacitor C0. Therefore, it is possible to realize the matching of the primary and secondary variable ranges and to realize the wide band of the attenuation pole.

The invention is not limited to the above-described embodiment, and may be modified within the scope of the invention. For example, the invention can be applied to a double-tuned circuit of a reception circuit that selectively receives a high band signal and a low band signal by switching inductors in the same manner, in addition to the television tuner. When the need to widen the attenuation pole is not great, the trap circuit formed of the capacitance C11 may be used on its own as a countermeasure, and the trap circuit formed of the capacitor C0 may be removed. The primary inductance element includes two inductors L1 and L2 connected to each other, but the end portion of the conductive pattern 31 and the anode of the switching element SD1 may be connected to a middle point of one inductor.

The invention is applicable to various tuner circuits for selectively receiving high band signals and low band signals by switching inductance values.

## Claims

1. A double-tuned circuit comprising:
a primary tuned circuit formed of a circuit having a first inductance element and a first variable capacitance element connected parallel to each other; and
a secondary tuned circuit formed of a circuit having a second inductance element opposed to the first inductance element and a second variable capacitance element connected parallel to each other,
wherein a trap circuit is formed by connecting a first capacitance between a connection point of the second inductance element and the second variable capacitance element and a middle point of the first inductance element.

2. The double-tuned circuit according to Claim 1, wherein a mixer circuit that converts a frequency by mixing a high frequency signal output from the secondary tuned circuit with an oscillation signal supplied from an oscillation circuit is connected to a rear end of the secondary tuned circuit, and
wherein an attenuation pole of the trap circuit is set for an oscillation frequency of the oscillation circuit.

3. The double-tuned circuit according to Claim 1 or 2, wherein the inductance values of the first and second inductance elements are switchable according to reception bands.

4. The double-tuned circuit according to one of Claims 1-3, wherein a second capacitance is connected between an output terminal of the secondary tuned circuit and the mixer circuit.

5. The double-tuned circuit according to one of Claims 1-4, wherein the first capacitance is formed of a conductive pattern formed from the connection point of the second inductance element and the second variable capacitance element to the middle point of the first inductance element.
